# FASCICULE DE BREVET EUROPEEN

(11) **EP 0 308 347 B1**
(45) Date de publication et mention de la délivrance du brevet: **24.11.1993**
(21) Numéro de dépôt: 88402347.4
(22) Date de dépôt: 16.09.1988
(51) Int. Cl.: G12B 9/08

(54) **Appareil manipulateur de tête de test à suspension ameliorée**
Prüfkopfmanipulator mit verbesserter Aufhängung
Test head robot having a modified suspension

(30) Priorité: 17.09.1987 FR 8713098; 17.09.1987 FR 8713099
(43) Date de publication de la demande: 22.03.1989
(73) Titulaire: SCHLUMBERGER INDUSTRIES, F-92120 Montrouge (FR)
(72) Inventeur: Beaucoup, Louis, F-42000 Saint Etienne (FR); Boncompain, Jean, F-42100 Saint Etienne (FR); Reynaud, Jean-Claude, F-04100 Manosque (FR)
(74) Mandataire: Ropital-Bonvarlet, Claude

(56) Documents cités:
- EP-A- 0 102 217
- DE-A- 2 225 408
- GB-A- 706 834
- US-A- 2 092 336
- US-A- 3 478 436

## Description

L'invention est relative au domaine technique des appareils manipulateurs conçus pour le support et l'orientation d'une tête de test électronique assurant l'interface de connexion entre un équipement de test automatique et des circuits électroniques, simples ou complexes, à tester, chargés sur une structure de présentation.

Les appareils du type ci-dessus sont destinés à permettre le réglage de position en site, en azimut et en orientation d'un support sur lequel la tête est montée, de manière à permettre, par déplacement manuel, l'accostage et la connexion de cette tête avec la structure de présentation des circuits électroniques à tester.

Les têtes de test électroniques sont des ensembles de poids élevé formés d'une structure de support et de protection contenant un grand nombre de circuits de contrôle prolongés extérieurement à la tête par des cables de connexion. Chaque circuit intégré à tester est successivement placé sur la tête de test en provenance d'une structure de présentation à laquelle la tête est mécaniquement connectée. Généralement, de telles têtes sont organisées sous forme de caissons de forme approximativement parallélépipédique susceptibles d'être supportés par deux tourillons fixés de part et d'autre du caisson. Comme le poids de la tête est uniformément réparti par rapport à ces tourillons, la tête est suspendue en équilibre indifférent par les deux tourillons.

D'autres têtes de test électroniques qui seront appelées ici "asymétriques" comprennent une enveloppe cylindrique prolongée radialement par un bras rigide qui contient des cables de connexion électriques et des conduites de refroidissement.

Les manipulateurs de têtes de test connus, comme celui décrit dans la demande de brevet européen EP-A-102 217, comprennent une colonne constituée par une poutre en forme de "H" sur laquelle un bras articulé est monté coulissant verticalement. Le bras articulé comporte deux axes verticaux nécessaires pour supporter le poids de la tête de test lorsque cette dernière est déplacée manuellement en s'écartant ou en se rapprochant de la colonne. Dans cet appareil, le bras articulé ne peut pas être déplacé en rotation de 360° autour de la colonne. La poutre en H a une longueur importante car son sommet doit être plus haut que la position la plus élevée de la tête de test de sorte que la colonne est lourde et encombrante. Un tel manipulateur comprend en outre des masses métalliques que l'on enlève ou que l'on rajoute pour équilibrer le poids de la tête de test. Ces masses métalliques ne sont pas pratiques à manipuler et ne permettent pas un réglage continu. En outre, le bras articulé n'autorise pas de déplacements horizontaux importants.

D'autres manipulateurs, décrits également dans la demande de brevet mentionnée ci-dessus, comportent des moyens d'équilibrage à air comprimé pour déplacer verticalement et supporter le poids de la tête de test. Ces moyens d'équilibrage sont compliqués car ils exigent un compresseur, un régulateur de pression et de préférence un système d'amortissement qui fonctionnent en permanence pour maintenir une pression constante lors des déplacements verticaux de la tête.

Un objet de l'invention est de proposer un appareil manipulateur ayant un faible encombrement vertical et offrant des possibilités de déplacement en site sur 360° tout autour de la colonne verticale de suspension.

Un autre objet de l'invention est de proposer un appareil manipulateur ayant un système d'équilibrage relativement simple, susceptible d'être réglé de façon continue et qui ne nécessite pas la manipulation de masses amovibles pour équilibrer le poids de la tête de test.

Ces objets et d'autres sont atteints par l'invention qui concerne un appareil manipulateur pour le support et l'orientation d'une tête de test comprenant :
- un premier organe de suspension fixé à un socle,
- un deuxième organe de suspension monté coulissant verticalement sur le premier organe de suspension,
- des moyens de positionnement pour monter mobile horizontalement un bloc sur le deuxième organe de suspension,
- un dispositif d'orientation pour monter la tête de test sur le bloc de façon qu'elle puisse être orientée par rapport au bloc,
- et des moyens d'équilibrage pour équilibrer le poids de la tête de test montée sur le dispositif d'orientation ,
   caractérisé en ce que :
   - le premier organe de suspension est tubulaire et le deuxième organe de suspension, également tubulaire, est monté télescopiquement et coaxialement sur le premier organe tubulaire autour d'un premier axe vertical,
   - les moyens de positionnement sont montés tournants tout autour d'un premier axe vertical sur le deuxième organe de suspension,
   - et les moyens d'équilibrage comprennent un câble relié au deuxième organe de suspension et des moyens de traction à ressort portés par le socle et à commande manuelle pour appliquer au câble une force de rappel continuellement réglable afin d'appliquer au deuxième organe de suspension une force ascendante qui équilibre le poids de l'ensemble formé par le deuxième organe de suspension, les moyens de positionnement, le dispositif d'orientation et la tête de test.

Diverses autres caractéristiques ressortiront de la description faite ci-dessous en référence aux dessins annexés qui montrent, à titre d'exemples non limitatifs, des formes de réalisation de l'objet de l'invention.

La figure 1 est une vue schématique en perspective illustrant un appareil manipulateur de support et d'orientation d'une tête de test électronique conforme à l'invention.

La figure 2 est une élévation en coupe partielle de la colonne et des moyens d'équilibrage de l'appareil de la figure 1.

Les figures 3, 4, 5 et 6 sont des vues en plan, en coupe partielle, prises respectivement selon les lignes III-III, IV-IV, V-V et VI-VI de la figure 2.

La figure 7 est une coupe-élévation en partie arrachée du dispositif d'orientation de l'appareil de la figure 1.

La figure 8 est une vue en plan, en partie arrachée, prise selon la ligne VIII-VIII de la figure 7.

La figure 9 est une coupe transversale selon la ligne IX-IX de la figure 7.

La figure 10 est une coupe-élévation partielle montrant, à plus grande échelle, une variante de réalisation des moyens de réglage de l'appareil manipulateur.

La figure 11 est une coupe prise selon la ligne XI-XI de la figure 10.

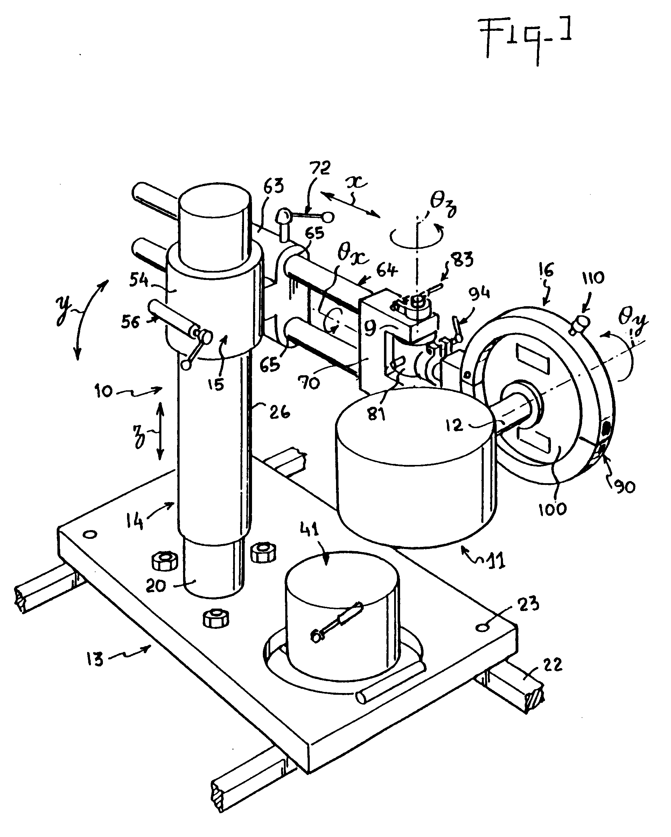

La figure 1 montre, de façon schématique, un appareil manipulateur 10 pour le support et l'orientation d'une tête de test électronique 11, du type asymétrique, pourvue d'un bras radial de fixation 12.

Un appareil, tel que 10, comprend, généralement, un socle 13 à partir duquel s'élève une colonne de suspension 14 pourvue de moyens de positionnement 15 capables d'assurer le déplacement d'un dispositif d'orientation 16 selon des directions générales x, y et z. Les moyens de positionnement 15 permettent de déplacer la tête de test 11 selon trois mouvements : une rotation (y) autour de la colonne 14, un mouvement de translation le long d'une direction horizontale (x) et une rotation autour d'un axe vertical (ϑz). Ajoutés au déplacement vertical autorisé par la colonne de suspension 14, ces trois mouvements permettent d'amener la tête de test 11 à n'importe quelle position tout autour de la colonne 14. Le dispositif d'orientation 16 permet deux mouvements supplémentaires de la tête de test 11 : une rotation autour d'un axe horizontal ϑx et une rotation autour d'un axe ϑy.

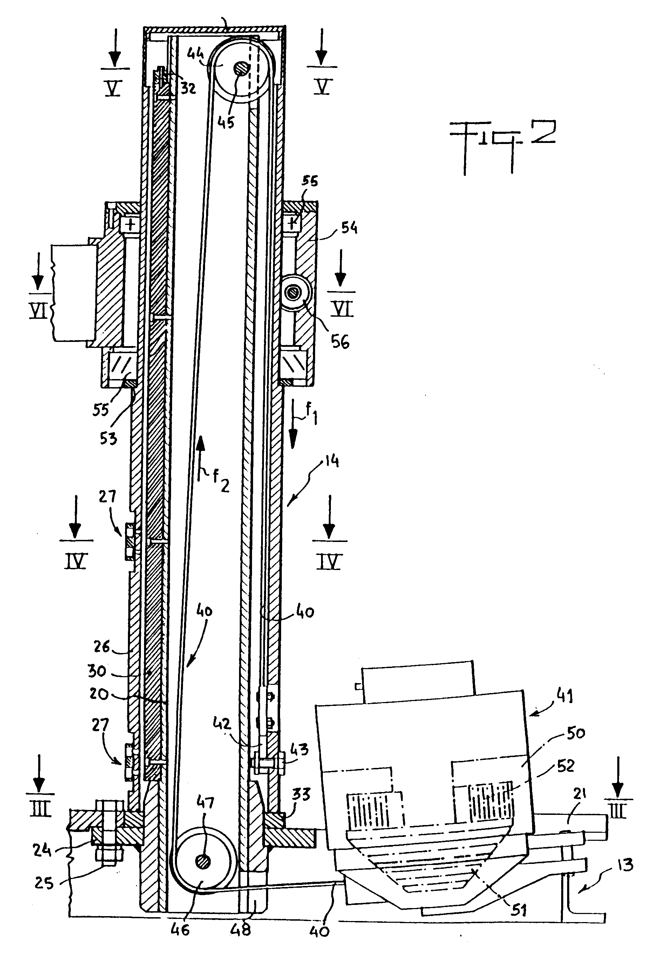

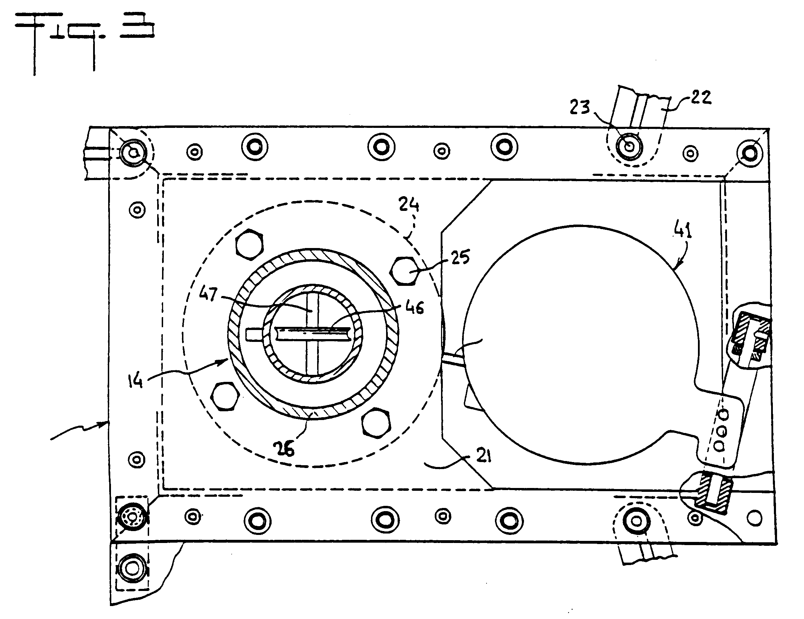

La colonne 14 comprend un organe de suspension fixe ou fût tubulaire 20 fixé au socle 13. Comme représenté sur les figures 2 et 3, le socle 13 comprend une embase 21, de toute forme géométrique appropriée, associée à des pieds 22 montés orientables sur des axes d'articulation verticaux 23. Les pieds 22 ne sont représentés que partiellement aux figures 1 et 3. Ils peuvent être réalisés de toute façon convenable en étant de longueur fixe ou réglable.

Comme représenté sur la figure 2, le fût tubulaire fixe 20 est fixé, par tout moyen convenable, sur l'embase 21. De préférence, le fût 20 comporte en pied une collerette 24 par laquelle il est fixé sur l'embase 21, notamment par l'intermédiaire de boulons 25.

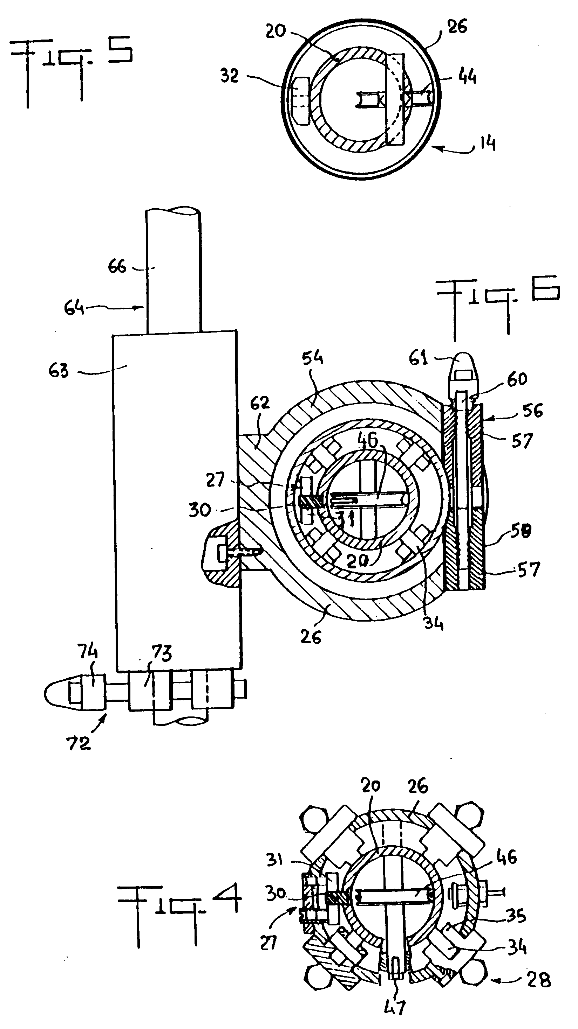

La colonne 14 comprend, par ailleurs, un organe de suspension mobile ou fourreau tubulaire 26 enfilé concentriquement sur le fût 20 avec lequel il coopère par des organes de guidage 27 et par des organes de centrage 28, illustrés plus en détail à la figure 4.

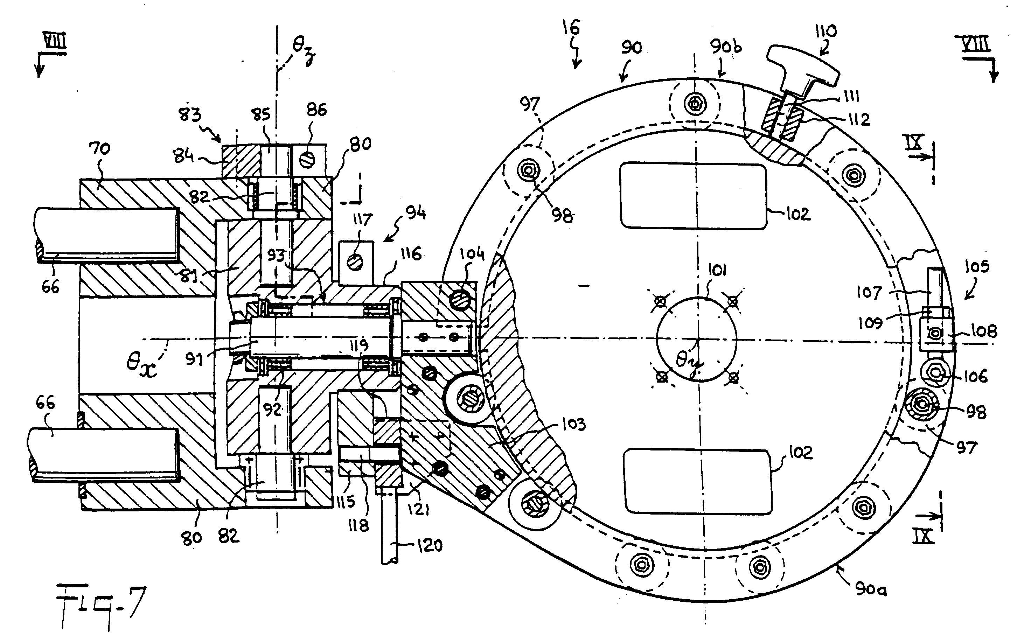

Les organes de guidage 27 empêchent le fourreau 26 de tourner autour du fût 20. Ils comprennent une règle axiale 30 qui est fixée à la périphérie du fût tubulaire fixe 20. Les organes 27 comprennent, par ailleurs, au moins deux jeux de deux galets 31 portés par le fourreau 26, de manière à coopérer pour chaque paire avec les deux faces latérales de la règle axiale 30. Les deux paires de galets 31 sont disposées à distance l'une de l'autre, à partir de l'extrémité inférieure du fourreau tubulaire 26 de manière à pouvoir coopérer avec la majeure partie de la longueur de la règle 30 et permettre ainsi le déplacement axial télescopique du fourreau 26 sur la majeure partie utile de la hauteur du fût tubulaire 20. La position d'extension maximale du fourreau 26 par rapport au fût 20 est déterminée par un taquet de butée 32 (figure 5) adapté à l'extrémité supérieure de la règle 30 pour s'opposer au déplacement des galets 31 de la paire supérieure 27. La position de rétraction maximale, telle qu'illustrée par la figure 2, est déterminée par l'amenée en butée de l'extrémité basse du fourreau 26 contre l'embase 21, soit directement, soit avec interposition d'une garniture 33, par exemple en élastomère, assumant une fonction de couronne d'appui et d'amortissement.

Les organes de centrage 28 sont principalement constitués par des galets 34 montés sur des chapes 35 portées par le fourreau 26 de manière à pouvoir rouler axialement sur la périphérie extérieure du fût 20. Les galets 34 sont organisés en deux séries distantes axialement d'une mesure, par exemple, égale à celle séparant les deux paires de galets 31. Les galets 34 sont équidistants angulairement dans chaque série. La figure 4 montre que, de façon préférée, chaque série comporte quatre galets 34 deux à deux diamétralement opposés. Les chapes 35 peuvent être réalisées de différentes façons possibles. Une structure appropriée consiste à leur faire comporter une collerette par laquelle elles sont fixées de façon amovible sur la surface extérieure du fourreau 26 que les chapes traversent librement.

Le fourreau 26 est ainsi guidé axialement et angulairement, tout en étant centré sur le fût 20 par rapport auquel il peut être déplacé avec un frottement minimal, en raison de la présence des galets 31 et 34. Le fourreau 26 peut ainsi être placé dans la position de rétraction correspondant à la hauteur minimale de la colonne 14 tel que cela est illustré par la figure 2. Par contre, le fourreau 26 peut aussi être élevé aisément jusque dans sa position d'extension maximale par coulissement télescopique jusqu'à la position de butée déterminée par l'appui de la première paire de galets 31 contre le taquet 32. Pour assurer et régler un tel coulissement, certains au moins des galets 31 et 34 sont montés par des bagues excentriques sur leurs axes.

Le manipulateur comprend des moyens d'équilibrage de poids de la tête de test. Le fourreau 26 est relié, par une transmission souple 40, à des moyens de traction réglables 41 portés par l'embase 21. La transmission souple 40 comprend un câble dont l'oeilleton d'extrémité 42 est accroché, par un moyen de fixation 43, à l'intérieur du fourreau 26 et à proximité de l'extrémité basse de ce dernier. Le câble 40 s'élève dans l'intervalle annulaire entre le fourreau 26 et le fût 20, pour être pris en charge par une poulie de renvoi 44 portée par un axe de rotation 45 fixé en tête du fût 20. Au-delà de la poulie 44, le câble 40 s'étend axialement à l'intérieur du fût 20 et passe sur une poulie de renvoi de pied 46 portée par un axe de rotation 47 fixé à la base du fût 20. Au-delà de la poulie de renvoi de pied 46, le câble 40 est orienté de façon sensiblement horizontale, à travers une lumière 48 du fût 20 pour être pris en charge par les moyens de traction 41.

Selon une disposition de l'invention, les moyens de traction 41 appliquent une traction élastique réglable au câble 40. Les moyens de traction 41 comprennent une enveloppe 50 fixée à l'embase 21 et contenant un tambour 51 ayant une gorge hélicoïdale à diamètre de spire progressivement croissant sur laquelle s'enroule le câble 40. Lorsque le fourreau 26 est en position haute, toutes les spires du câble 40 sont enroulées sur le tambour 51. Dans l'enveloppe 50, les moyens de traction 41 comprennent aussi un ressort à lame 52 du type spiral dont la main d'accrochage interne est ancrée sur le tambour 51. Le réglage des moyens de traction 41 est effectué, selon le poids de la tête de test, de manière à amener verticalement la tête de test à une position neutre choisie pour laquelle l'action de traction élastique compense le poids de l'équipage mobile incluant la tête, ce poids s'appliquant au câble 40 dans le sens des flèches f₁ et f₂.

Le tambour 51 est réalisé pour compenser les variations de force du ressort spiral 52 lorsque le câble est enroulé ou déroulé du tambour 51. Par conséquent, la force appliquée par les moyens de traction 41 est sensiblement constante sur une plage de positions verticales de part et d'autre de la position neutre. La tête de test peut ainsi être déplacée verticalement sans effort sur cette plage de positions pour être amenée à son emplacement précis d'accostage.

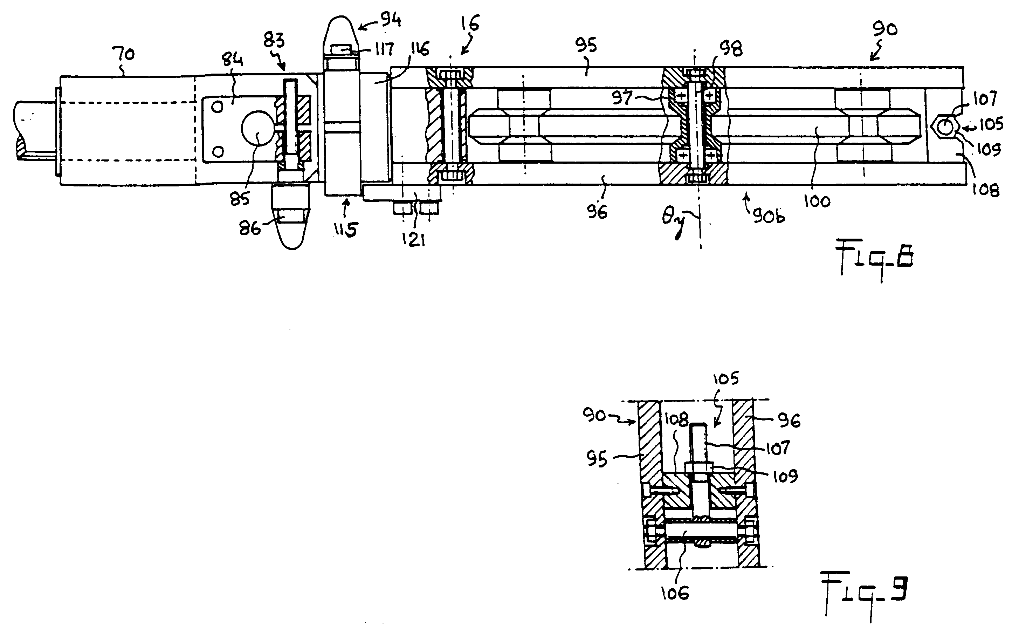

Le fourreau 26 comporte, à distance de son extrémité supérieure, un épaulement 53 sur lequel prend appui axialement une bague support 54 par ailleurs centrée sur le fourreau 26 par l'intermédiaire d'un roulement et d'une butée à billes ou à rouleaux 55. La bague 54 peut ainsi tourner librement avec un frottement minimal par rapport au fourreau 26 et sur une plage angulaire égale à 360°. La bague 54 est associée (figure 6) à un mécanisme 56 de blocage angulaire, de tout type convenable. De préférence, le mécanisme 56 est constitué par un ou deux manchons tubulaires cylindriques 58 traversant, de façon sécante, la bague 54 et assurant le guidage axial de deux noix 57 vissées sur des parties filetées à pas inverse d'une tige de commande 60 pourvue d'une poignée 61 d'entraînement en rotation. Le ou les manchons 58 sont réalisés de manière que les noix 57 puissent faire partiellement saillie au-delà d'eux, afin de pouvoir être amenées à serrer le fourreau 26 lorsque, par rotation de la tige 60 dans le sens correspondant, elles sont sollicitées en rapprochement mutuel axial à l'intérieur du manchon 58.

Le mécanisme 56 permet d'immobiliser très précisément la bague 54 selon une orientation angulaire quelconque.

La bague 54 porte, par une platine 62, de préférence diamétralement opposée au mécanisme 56, un corps 63 de guidage d'un bras horizontal 64 de support d'une tête de test électronique. Le corps de guidage 63 définit au moins une et, de préférence, deux coulisses 65 parallèles entre elles, superposées, disposées dans un même plan vertical parallèle à l'axe de la colonne et déportées par rapport à ce dernier. Les coulisses 65 assurent le support et le guidage de deux barres 66 constitutives du bras 64. Les barres 66 sont réunies, à une de leurs extrémités, par un corps 70 d'articulation du dispositif d'orientation 16. Le corps de guidage 63 est pourvu d'au moins un mécanisme 72 d'immobilisation axiale du bras 64. Le mécanisme 72 peut être constitué par une bride ouverte 73 associée à un organe de serrage 74 du type à vis et traversé par au moins une glissière 66. Le serrage de la vis 74 ferme la bride ouverte 73 qui serre la glissière 66, de cette façon immobilisée axialement par rapport au corps 63.

La colonne 14 décrite ci-dessus se caractérise par un faible encombrement vertical dû à sa réalisation au moyen d'un fût fixe tubulaire 20 et d'un fourreau télescopique 26 immobilisé angulairement sur le fût. La possibilité de coulissement axial du fourreau 26 permet de placer la bague 54 soit dans une position de hauteur minimale telle qu'illustrée par la figure 2, soit en toute position intermédiaire jusqu'à une hauteur maximale correspondant à l'extension du fourreau 26 par rapport au fût 20 et limitée par le taquet de butée 32.

La bague 54 permet d'orienter le bras 64 en toutes positions angulaires sur une plage de 360°, ce bras pouvant être immobilisé à volonté dans n'importe quelle orientation.

La disposition du corps de guidage 63 déporté latéralement par rapport à l'axe de rotation verticale de la bague 54 permet de dégager le bras 64 de l'aplomb du socle 13 lorsqu'il convient d'aménager ou de faciliter l'approche relative de la tête par rapport à l'unité de traitement de l'équipement de test ou à la structure de présentation des circuits à tester.

L'existence d'un bras 64 en porte-à-faux constitué, de préférence, par deux barres situées dans un même plan vertical, contribue à assurer un maintien particulièrement stable d'une tête de test, même d'un poids très élevé.

Les moyens de traction réglable 41 de faible encombrement et dont la fonction d'équilibrage de poids s'effectue par application d'une traction élastique compensée permet à l'utilisateur un réglage facile et continu, en fonction du poids de la tête de test, sans nécessiter de manipulation de masses d'équilibrage.

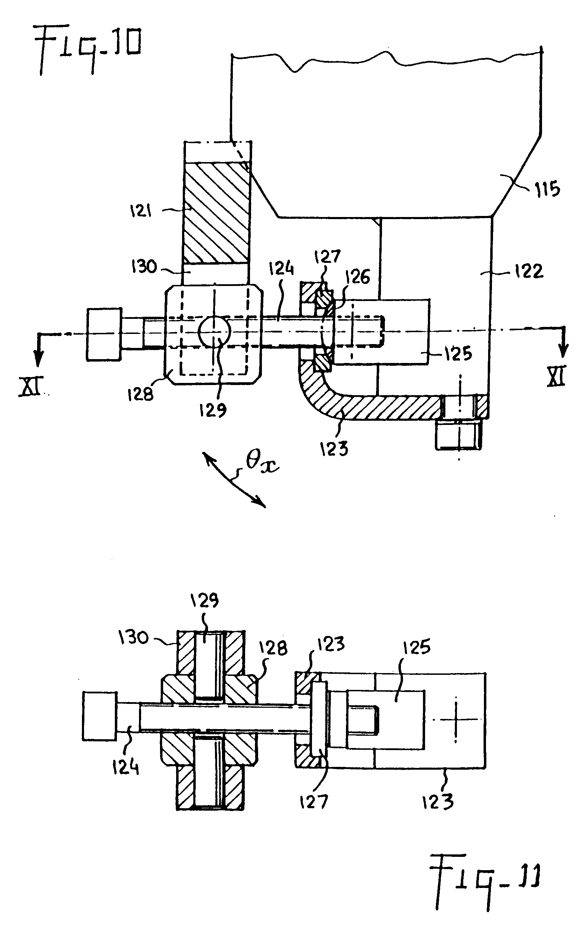

En référence aux figures 7 et 8, le corps d'articulation 70 fixé à l'extrémité des glissières 66 est réalisé sous la forme générale d'un étrier disposé, habituellement, pour que les branches parallèles 80 qu'il comporte soient superposées verticalement. Un bloc d'adaptation 81 est monté tournant sur le corps d'articulation 70. Le bloc d'adaptation 81 est monté entre les branches 80 par l'intermédiaire de deux tourillons 82 qui définissent un axe de rotation vertical ϑz, généralement parallèle à la colonne 14. Différentes solutions techniques peuvent être choisies pour assurer le support et la rotation libre du bloc 81 entre les branches 80 par l'intermédiaire des tourillons 82. La rotation libre, entre le bloc 81 et le corps 70, peut être bloquée par l'intermédiaire d'un moyen de blocage angulaire 83 à commande manuelle. Le moyen de blocage 83 est, par exemple, constitué par une bride ouverte 84 fixée sur la branche supérieure 80 du corps 70 pour entourer un prolongement 85 du tourillon supérieur 82. La bride 84 est associée à un organe de serrage 86 capable de l'ouvrir ou de la fermer, pour libérer ou bloquer angulairement le prolongement 85 du tourillon 82 angulairement immobilisé sur le bloc 81.

Le dispositif d'orientation 16 comporte un cadre annulaire ou lunette 90 pourvue extérieurement d'une queue cylindrique 91 de direction radiale qui est montée, par l'intermédiaire de roulements 92, dans un palier 93 du bloc 81, définissant un axe de rotation ϑx de direction sensiblement horizontale coupant l'axe ϑz. Le bloc 81 supporte des moyens 94 de réglage et de maintien en position angulaire de la lunette 90 sur l'axe ϑx qui seront décrits par la suite.

La lunette 90 est, de préférence, constituée par deux anneaux 95 et 96 (figure 8) maintenus parallèlement par des entretoises 98. Les anneaux parallèles 95 et 96 retiennent entre eux des organes de centrage 97 qui sont constitués par des galets montés libres de tourner sur les entretoises 98. Les organes de centrage 97 sont prévus pour assurer le support et le centrage d'une galette 100 circulaire en définissant, pour cette dernière, un axe de rotation ϑy confondu avec l'axe géométrique de la lunette 90. De préférence, les galets 97 sont réalisés sous forme de diabolos emboîtant le bord périphérique complémentaire de la galette 100. A titre d'exemple, la galette 100, plus particulièrement destinée au support de la tête de test électronique 11, comporte en son centre des moyens 101 d'adaptation et de fixation du bras 12 et des fenêtres 102 de passage et/ou de raccordement de connecteurs électriques issus de la tête 11.

De manière à faciliter le montage et/ou le changement de la galette 100, la lunette 90 est, de préférence, constituée par un premier arceau 90a, dit fixe, s'étendant à partir d'une chape 103 portant la queue 91. La chape 103 est pourvue d'un axe de pivotement 104 parallèle à l'axe de rotation ϑy. L'axe 104 porte un second arceau 90b susceptible de pivoter dans le plan vertical d'une position d'ouverture dans laquelle il dégage, par rapport à l'arceau fixe, une section de passage au moins égale au diamètre de la galette 100, à une position de fermeture dans laquelle il reconstitue la lunette 90 avec l'arceau 90a. La liaison d'assemblage temporaire entre les arceaux 90a et 90b est assurée par un organe 105, par exemple constitué par un axe 106 monté tourillonnant entre les demi-anneaux constitutifs de l'arceau 90a. L'axe 106 est prolongé par une tige filetée radiale 107 destinée à s'engager dans une fourchette 108 derrière laquelle prend appui un écrou de serrage 109 (figure 9).

Les arceaux 90a et 90b sont chacun constitués par des demi-anneaux assemblés entre eux, comme dit précédemment, et assurant le maintien des organes de centrage 97 qu'ils portent.

La lunette 90 est pourvue d'un organe 110 de blocage angulaire de la galette 100 sur l'axe de rotation ϑy. Un tel organe 110 est, par exemple, constitué par une vis de pression 111 traversant un écrou fixe 112 porté par la lunette 90, de manière à prendre appui, selon une direction radiale, sur le bord périphérique de la galette 100. Il est évident que des moyens techniques différents pourraient être envisagés pour assumer la même fonction.

Comme mentionné précédemment, le manipulateur comprend des moyens 94 de réglage et de maintien en position angulaire de la lunette 90 sur l'axe ϑx.

Les moyens de réglage 94 peuvent comporter une bride ouverte 115 qui est montée fixe sur une portée cylindrique 116 formée par le bloc d'adaptation 81 concentriquement à l'axe du palier 93. La bride ouverte 115 est immobilisée angulairement sur la portée 116 par l'intermédiaire d'une vis 117 traversant les deux branches de ladite bride délimitée par la fente qu'elle présente.

A l'opposé de la vis 117, la bride 115 porte un axe 118 sur lequel est montée une came excentrique 119 libre de tourner. La came excentrique 119 est prolongée par une tige de manoeuvre 120 et sa surface externe vient en appui sur une plaque 121 portée par la chape 103 de la lunette 90.

Lorsque l'excentrique 118 tourne autour de son axe 118, il écarte plus ou moins la plaque 121 de la bride 115, ce qui déplace en rotation la lunette 90 par rapport au bloc 81 autour de l'axe ϑx.

Une variante de réalisation, illustrée par les figures 10 et 11, montre que la bride 115 peut porter à sa partie inférieure un pied 122 portant une barrette de butée 123 traversée librement par une vis 124 du type micrométrique. A une extrémité de la vis 124 est fixé un écrou 125 prenant appui derrière la butée 123 par une portée en calotte sphérique 126 emboîtée dans un siège complémentaire 127 de la butée. La vis 124 coopère, en avant de la butée 123, avec une noix taraudée 128 montée libre de pivoter par des tourillons 129 parallèles à l'axe ϑx du palier 93 sur une chape 130 définie par la plaque 121 ou tout autre pièce analogue portée par la chape 103.

Avec l'un ou l'autre de ces modes de réalisation, l'utilisateur peut procéder au réglage angulaire de la position autour de l'axe ϑx, de la lunette 90 portant la tête de test tout en empêchant la lunette 90 de basculer autour de cet axe sous l'effet du poids en déséquilibre de la tête.

Ce réglage est limité à une certaine plage de positions angulaires de la lunette 90 autour de l'axe ϑx. Dans les modes de réalisation décrits, la plage de réglage possible allait de + 5° à - 5° autour de la position de la lunette 90 pour laquelle l'axe ϑy était horizontal.

Ainsi que cela ressort de ce qui précède, le manipulateur comporte un dispositif d'orientation **16** particulièrement adapté au support d'une tête de test électronique, du type asymétrique, comportant un bras de fixation radial fixe dans la galette **100**. Une telle tête, ainsi que cela ressort de la **figure 1**, peut ainsi être aisément fixée en porte-à-faux, de telle manière que son bras radial **12** soit aligné avec l'axe de rotation **ϑy** autour duquel la tête **11** peut être orientée, de façon simple et aisée, par rotation de la galette **100**. La galette peut être immobilisée angulairement par l'organe de blocage **110**.

La tête **11** peut aussi être réglée et orientée autour de l'axe de rotation **ϑx**, avec un mouvement limité, en faisant tourner la lunette **90** sur cet axe par les moyens de réglage **94**;
Le dispositif selon l'invention assure ainsi, de façon pratique, rapide, efficace, le support d'une tête de type asymétrique à bras radial de fixation en porte-à-faux tout en permettant de déplacer manuellement cette tête selon les différents degrés de liberté désirés.

On remarquera qu'à l'exception des moyens de réglage **94**, les différents blocages peuvent être tous libérés après le positionnement de la tête et son accostage à un dispositif de présentation des circuits à tester. La tête garde alors sa position, sans subir de contraintes de la part du manipulateur.

## Revendications

1. Appareil manipulateur pour le support et l'orientation d'une tête de test (**11**) comprenant :
- un premier organe de suspension (**20**) fixé à un socle (**13**),
- un deuxième organe de suspension (**26**) monté coulissant verticalement sur le premier organe de suspension (**20**),
- des moyens de positionnement (**15**) pour monter mobile horizontalement un bloc (**81**) sur le deuxième organe de suspension (**26**),
- un dispositif d'orientation (**16**) pour monter la tête de test (**11**) sur le bloc (**81**) de façon qu'elle puisse être orientée par rapport au bloc (**81**),
- et des moyens d'équilibrage (**40,41**) pour équilibrer le poids de la tête de test (**11**) montée sur le dispositif d'orientation (**16**),
caractérisé en ce que :
- le premier organe de suspension (**20**) est tubulaire et le deuxième organe de suspension (**26**), également tubulaire, est monté télescopiquement et coaxialement sur le premier organe tubulaire (**20**) autour d'un premier axe vertical,
- les moyens de positionnement sont montés tournants tout autour d'un premier axe vertical sur le deuxième organe de suspension (**26**),
- et les moyens d'équilibrage (**40,41**) comprennent un câble (**40**) relié au deuxième organe de suspension (**26**) et des moyens de traction à ressort (**41**) portés par le socle (**13**) et à commande manuelle pour appliquer au câble (**40**) une force de rappel continuellement réglable afin d'appliquer au deuxième organe de suspension (**26**) une force ascendante qui équilibre le poids de l'ensemble formé par le deuxième organe de suspension (**26**), les moyens de positionnement (**15**), le dispositif d'orientation (**16**) et la tête de test (**11**).

2. Appareil selon la revendication 1, caractérisé en ce qu'il comprend de plus des moyens (**27**) pour empêcher la rotation du deuxième organe tubulaire (**26**) par rapport au premier organe tubulaire (**20**) autour du premier axe vertical.

3. Appareil selon la revendication 1, caractérisé en ce qu'il comprend des organes de centrage (**28**) constitués par des galets (**34**) montés tournants sur l'un des organes tubulaires (**20,26**) et roulant sur l'autre des organes tubulaires (**20,26**) pour guider le mouvement vertical du deuxième organe tubulaire (**26**) sur le premier organe tubulaire (**20**).

4. Appareil selon la revendication 1, caractérisé en ce qu'il comprend de plus des moyens de guidage (**44,46**) du câble (**40**) pour guider le câble sur un trajet partant du bas du deuxième organe tubulaire (**26**), passant entre les deux organes tubulaires (**20, 26**) et se prolongeant jusqu'au bas du premier organe tubulaire (**20**).

5. Appareil selon la revendication 4, caractérisé en ce que les moyens de guidage du câble (**40**) comprennent une première poulie (**44**) montée tournante au sommet du premier organe tubulaire (**20**) et une deuxième poulie (**46**) montée tournante au bas du premier organe tubulaire (**20**).

6. Appareil selon l'une des revendications précédentes, caractérisé en ce que les moyens de traction (**41**) comprennent :
- une enveloppe (**50**) fixée au socle (**13**)
- un tambour (**51**) sur lequel s'enroule le câble (**40**) et
- un ressort spiral réglable (**52**) relié au tambour (**51**) pour lui appliquer une force de rappel réglable, afin d'enrouler le câble (**40**) sur le tambour, le tambour comportant des moyens de compensation pour compenser les variations de la force appliquée par le ressort (**52**) pour une plage de positions angulaires de ce tambour, de façon que le poids de la tête de test soit sensiblement équilibrée pour une plage de positions verticales sans modifier le réglage du ressort (**52**).

7. Appareil selon la revendication **6**, caractérisé en ce que les moyens de compensation sont formés par une surface du tambour (**51**) de diamètre progressivement variable sur laquelle s'enroule le câble (**40**).

8. Appareil selon l'une des revendications précédentes, caractérisé en ce que les moyens de positionnement (**15**) comprennent :
- un premier support (**54,63**) monté tournant sur le deuxième organe de suspension (**26**) autour du premier axe vertical,
- et un deuxième support (**70**) monté coulissant horizontalement sur le premier support (**54**), le bloc (**81**) étant monté tournant sur le deuxième support (**70**) autour d'un deuxième axe vertical (**ϑz**).

9. Appareil selon la revendication 8, caractérisé en ce que le deuxième support (**70**) est solidaire de deux barres (**66**) superposées parallèles l'une de l'autre, montées coulissantes dans deux coulisses (**65**) du premier support (**54,63**).

10. Appareil selon la revendication 8 ou 9, caractérisé en ce qu'il comprend des premiers moyens de blocage (**56**) à commande manuelle pour bloquer en rotation le premier support (**54,63**) sur le deuxième organe de suspension (**26**) et des deuxièmes moyens de blocage (**72**) à commande manuelle pour bloquer le mouvement horizontal du deuxième support (**70**) par rapport au premier (**54,63**).

11. Appareil selon la revendication 10, caractérisé en ce qu'il comprend de plus des troisièmes moyens de blocage (**83**) à commande manuelle pour bloquer en rotation le bloc (**81**) sur le deuxième support (**70**) autour du deuxième axe vertical (**ϑz**).

12. Appareil selon l'une des revendications précédentes dans lequel la tête de test est prolongée par un bras radial (**12**), caractérisé en ce que le dispositif d'orientation (**16**) comprend un cadre (**90**) monté tournant sur le bloc (**81**) autour d'un axe (**ϑx**) et des moyens pour monter tournant le bras radial (**12**) de la tête de test (**11**) sur le cadre (**90**) autour d'un axe supplémentaire (**ϑy**) perpendiculaire à l'axe horizontal (**ϑx**).

13. Appareil selon la revendication 12, caractérisé en ce que les moyens pour monter tournant le bras radial (**12**) comprennent des organes de centrage (**97**) disposés sur le cadre (**90**) à égales distances de l'axe supplémentaire (**ϑy**) et une galette (**100**) montée en appui sur les organes de centrage (**97**) pour pouvoir tourner autour de l'axe supplémentaire (**ϑy**), le bras radial (**12**) de la tête de test (**11**) étant fixé à la galette (**100**).

14. Appareil selon la revendication 13, caractérisé en ce que le cadre (**90**) comprend une première partie (**90a**) montée tournante sur le bloc (**81**) autour de l'axe horizontal (**ϑx**) et adaptée à entourer partiellement la galette (**100**) et une deuxième partie (**90b**) montée pivotante par rapport à la première partie (**90a**) entre une position fermée pour laquelle la galette (**100**) est maintenue entre les deux parties du cadre (**90**) et une position ouverte pour laquelle la galette (**100**) peut être dégagée du cadre (**90**) avec la tête de test (**11**) fixée à la galette.

15. Appareil selon la revendication 13 ou 14, caractérisé en ce qu'il comprend un organe de blocage (**110**) à commande manuelle, monté sur le cadre (**90**) pour empêcher la rotation de la galette (**100**) autour de l'axe supplémentaire (**ϑy**).

16. Appareil selon l'une des revendications 12 à 15, caractérisé en ce qu'il comprend de plus des moyens de réglage (**94**) pour maintenir, par rapport au bloc (**81**) le cadre (**90**) dans une position angulaire réglable stable autour de l'axe horizontal (**ϑx**) afin d'empêcher la tête de test de s'incliner autour de cet axe horizontal (**ϑx**) sous l'effet de son poids.

17. Appareil selon la revendication 16, caractérisé en ce que les moyens de réglage (**94**) comprennent des moyens de liaison manuellement réglables disposés entre le bloc (**81**) et le cadre (**90**) pour déplacer le cadre (**90**) par rapport au bloc (**81**) sur une plage limitée de positions angulaires autour de l'axe horizontal (**ϑx**).

18. Appareil selon la revendication 17, caractérisé en ce que les moyens de réglage (**94**) comprennent une vis réglable (**124**) reliant le bloc (**81**) au cadre (**90**) de façon qu'une rotation manuelle de la vis (**124**) entraine la rotation du cadre (**90**) par rapport au bloc (**81**) autour de l'axe horizontal (**ϑx**).

19. Appareil selon la revendication 17, caractérisé en ce que les moyens de réglage (**94**) comprennent une came (**119**) montée tournante sur le bloc (**81**) autour d'un axe (**118**) parallèle à l'axe horizontal (**ϑx**) et venant en appui sur le cadre (**90**) de façon qu'une rotation manuelle de la came (**119**) entraîne la rotation du cadre (**90**) par rapport au bloc (**81**) autour de l'axe horizontal (**ϑx**).

## Claims

1. Manipulator apparatus for the support and directional-adjusting of a test head (11) comprising :
- a first suspension member (20) fixed to a base (13),
- a second suspension member (26) mounted for vertical sliding on said first suspension member (20),
- positioning means (15) for mounting a block (81) for horizontal movement on the second suspension member (26),
- a directional-adjustment device (16) for mounting the test head (11) on the block (81), such that it can be directionally-adjusted with respect to the block (81), and
- balancing means (40,41) for balancing the weight of the test head (11) mounted on the directional-adjustment device (16),
characterized in that :
- the first suspension member (20) is tubular and the second suspension member (26), also tubular, is telescopically and coaxially mounted on the first tubular member (20) about a first vertical axis,
- the positioning means are mounted for rotating all around a first vertical axis on the second suspension member (26), and
- the balancing means (40, 41) comprise a cable (40) connected to the second suspension member (26) and spring-mounted traction means (41) borne by the base (13) and operated manually to apply to the cable (40) a restoring force which is continually controllable in order to apply to the second suspension member (26) a lifting force which balances the weight of the assembly composed of the second suspension member (26), the positioning means (15), the directional-adjustment device (16) and the test head (11).

2. Apparatus according to claim 1, characterized in that it further comprises means (27) for preventing the rotation of the second tubular member (26) with respect to the first tubular member (20) about the first vertical axis.

3. Apparatus according to claim 1, characterized in that it comprises centering means (28) constituted by rollers (34) rotatably mounted on one of the tubular members (20, 26) and running on the other of the tubular members (20, 26) in order to guide the vertical movement of the second tubular member (26) on the first tubular member (20).

4. Apparatus according to claim 1, characterized in that it further comprises guiding means (44, 46) for the cable (40) for guiding the cable along a path starting from the bottom of the second tubular member (26), passing between the two tubular members (20, 26) and extending as far as the bottom of the first tubular member (20).

5. Apparatus according to claim 4, characterized in that the means for guiding the cable (40) comprise a first pulley (44) rotatably mounted et the top of the first tubular member (20) and a second pulley (46) rotatably mounted at the bottom of the first tubular member (20).

6. Apparatus according to one of the preceding claims, characterized in that the traction means (41) comprise:
- an envelope (50) fixed to the base (13),
- a drum (51) on which is wound the cable (40) and
- an adjustable spiral spring (52) which is joined to the drum (51) so as to apply on the latter an adjustable restoring force, with a view to winding the cable (40) on the drum, said drum comprising compensation means for compensating the variations of the force applied by the spring (52) through a range of angular positions of said drum, so that the weight of the test head is substantially balanced through a range of vertical positions without altering the adjustment of the spring (52).

7. Apparatus according to claim 6, characterized in that the compensation means are formed by a surface of the drum (51) of progressively varying diameter on which is wound the cable (40).

8. Apparatus according to one of the preceding claims, characterized in that the positioning means (15) comprise:
- a first support (54, 63) rotatably mounted on the second suspension member (26) about the first vertical axis, and
- a second support (70) mounted for horizontal sliding on the first support (54), the block (81) being rotatably mounted on the second support (70) about a second vertical axis (0z).

9. Apparatus according to claim 8, characterized in that the second support (70) is fast with two bars (66) superposed and parallel to one another, said bars being mounted for sliding in two slide guides (65) of the first support (54, 63).

10. Apparatus according to claim 8 or 9, characterized in that it comprises first manually operated locking means (56) for locking the first support (54, 63) in rotation on the second suspension member (26) and second manually operated locking means (72) for locking the horizontal movement of the second support (70) with respect to the first (54, 63).

11. Apparatus according to claim 10, characterized in that it further comprises third manually operated locking means (83) for locking the block (81) in rotation on the second support (70) about the second vertical axis (0z).

12. Apparatus according to one of the preceding claims in which the test head is extended by a radial arm (12), characterized in that the directional-adjustment device (16) comprises a frame (90) rotatably mounted on the block (81) about an axis (0x) and means for rotatably mounting the radial arm (12) of the test head (11) on the frame (90) about an additional axis (0y) perpendicular to the horizontal axis (0x).

13. Apparatus according to claim 12, characterized in that the means for rotatably mounting the radial arm (12) comprise centering members (97) disposed on the frame (90) at equal distance from the additional axis (0y) and a disk (100) mounted in such a way as to bear against the centering members (97) so as to be able to turn about the additional axis (0y), the radial arm (12) of the test head (11) being fixed to the disk (100).

14. Apparatus according to claim 13, characterized in that the frame (90) comprises a first part (90a) rotatably mounted on the block (81) about the horizontal axis (0x) and adapted to partly surround the disk (100) and a second part (90b) mounted for pivoting with respect to the first part (90a) between a closed position in which the disk (100) is held between the two parts of the frame (90) and an open position in which the disk (100) can be released from the frame (90) with the test head (11) being fixed to the disk.

15. Apparatus according to claim 13 or 14, characterized in that it comprises a manually operated locking member (110), mounted on the frame (90) so as to prevent the rotation of the disk (100) about the additional axis (0y).

16. Apparatus according to one of claims 12 to 15, characterized in that it further comprises adjusting means (94) for keeping the frame (90), with respect to the block (81), in a stable adjustable angular position about said horizontal axis (0x), so as to prevent the test head from tilting under its weight about said additional axis (0x).

17. Apparatus according to claim 16, characterized in that the adjusting means (94) comprise manually adjustable connection means disposed between the block (81) and the frame (90) in order to move the frame (90) with respect to the block (81) over a limited range of angular positions about the horizontal axis (0x).

18. Apparatus according to claim 17, characterized in that the adjusting means (94) comprise an adjustable screw (124) joining the block (81) to the frame (90) in such a way that a manual rotation of the screw (124) will cause the rotation of the frame (90) with respect to the block (81) about the horizontal axis (0x).

19. Apparatus according to claim 17, characterized in that the adjusting means (94) comprise a cam (119) rotatably mounted on the block (81) about an axis (118) parallel to the horizontal axis (0x) and coming to bear against the frame (90) such that a manual rotation of the cam (119) will cause the rotation of the frame (90) with respect to the block (81) about the horizontal axis (0x).

## Patentansprüche

1. Handhabungsgerät für das Lagern und Ausrichten eines Prüfkopfes (11) mit:
- einem ersten Aufhängungsorgan (20), das an einem Sockel (13) befestigt ist,
- einem zweiten Aufhängungsorgan (26), das vertikal gleitend an dem ersten Aufhängungsorgan (20) angebracht ist,
- Positioniereinrichtungen (15) zum horizontal beweglichen Anbringen eines Blockes (81) an dem zweiten Aufhängungsorgan (26),
- einer Ausrichtvorrichtung (16) zum Anbringen des Prüfkopfes (11) an dem Block (81) derart, daß er bezüglich des Blockes (81) ausgerichtet werden kann, und
- Ausgleichseinrichtungen (40,41), um das Gewicht des Prüfkopfes (11), der an der Ausrichtvorrichtung (16) angebracht ist, auszugleichen, dadurch gekennzeichnet, daß:
- das erste Aufhängungsorgan (20) rohrförmig ist, und das zweite Aufhängungsorgan (26), das ebenfalls rohrförmig ist, teleskopisch und koaxial an dem ersten rohrförmigen Organ (20) um eine erste vertikale Achse angebracht ist,
- die Positioniereinrichtungen drehbar um eine erste vertikale Achse an dem zweiten Aufhängungsorgan (26) angebracht sind und
- die Ausgleichseinrichtungen (40,41) ein Kabel oder Seil (40) aufweisen, das mit dem zweiten Aufhängungsorgan (26) verbunden ist und federbelastete Zugeinrichtungen (41) aufweisen, die von dem Sockel (13) gestützt sind und manuell bedienbar sind, um auf das Seil (40) eine kontinuierlich einstellbare Rückholkraft auszuüben, um auf das zweite Aufhängungsorgan (26) eine absteigende Kraft aufzubringen, die das Gewicht der Anordnung gebildet aus dem zweiten Aufhängungsorgan (26), den Positioniereinrichtungen (15), der Ausrichtvorrichtung (16) und dem Prüfkopf (11) gebildet ist, auszugleichen.

2. Gerät nach Anspruch 1, dadurch gekennzeichnet, daß es weiterhin Einrichtungen (27) ausweist, die eine Drehung des zweiten rohrförmigen Organs (26) bezüglich des ersten rohrförmigen Organs (20) um die erste vertikale Achse verhindern.

3. Gerät nach Anspruch 1, dadurch gekennzeichnet, daß es Zentrierungsorgane (28) aufweist, die aus Walzen (34) gebildet sind, die drehbar an einem der rohrförmigen Organe (20,26) angebracht sind und auf dem anderen rohrförmigen Organ (20,26) rollen, um die vertikale Bewegung des zweiten rohrförmigen Organs (26) auf dem ersten rohrförmigen Organ (20) zu führen.

4. Gerät nach Anspruch 1, dadurch gekennzeichnet, daß es weiterhin Führungseinrichtungen (44,46) des Seils (40) aufweist, um das Seil auf einem Weg zu führen, der unten am zweiten rohrförmigen Organ (26) beginnt, zwischen den beiden rohrförmigen Organen (20,26) vorbeigeht, und sich bis unten an das erste rohrförmige Organ (20) sich verlängert.

5. Gerät nach Anspruch 4, dadurch gekennzeichnet, daß die Führungseinrichtungen des Kabels (40) eine erste Trommel (44), die drehbar um die Spitze des ersten rohrförmigen Organs (20) und eine Zweite Trommel (46) aufweisen, die drehbar unten am ersten rohrförmigen Organ (20) angeordnet ist.

6. Gerät nach einem der vorhergehenden Ansprüche, dadurch gekennzeichnet, daß die Zugeinrichtungen (41) aufweisen:
- eine Hülle (50), die an dem Sockel (13) befestigt ist,
- eine Trommel (51), auf der das Kabel oder Seil (40) aufgerollt wird, und
- eine einstellbare Spiralfeder (52), die mit der Trommel (51) verbunden ist, um auf diese eine einstellbare Rückholkraft auszuüben, um darauf das Seil oder Kabel (40) auf die Trommel aufzuwickeln, wobei die Trommel Kompensationseinrichtungen aufweist, um die Veränderungen von der Feder (52) für die Mehrzahl von Winkelstellungen der Trommel aufgebrachte Kraft zu kompensieren,_{,} derart, daß das Gewicht des Prüfkopfes im wesentlichen für eine Mehrzahl von vertikalen Stellungen ausgeglichen wird, ohne daß die Einstellung der Feder (52) verändert wird.

7. Gerät nach Anspruch 6, dadurch gekennzeichnet, daß die Kompensationseinrichtungen durch eine Trommeloberfläche (51) von zunehmend veränderlichem Durchmesser gebildet werden, auf der sich das Kabel (40) aufrollt.

8. Gerät nach einem der vorhergehenden Ansprüche, dadurch gekennzeichnet, daß die Positioniereinrichtungen (15) aufweisen:
- eine erste Stütze (54,63), die drehbar auf dem zweiten Aufhängungsorgan (26) um eine erste vertikale Achse angebracht ist, und
- eine zweite Stütze (70), die horizontal gleitbeweglich an der ersten Stütze (54) angebracht ist, wobei der Block (81) drehbar an der zweiten Stütze (70) um eine zweite vertikale Achse (ϑz) angebracht ist.

9. Gerät nach Anspruch 8, dadurch gekennzeichnet, daß die zweite Stütze (70) mit zwei Stangen (66) verbunden ist, die parallel zueinander übereinander angeordnet und gleitbeweglich in zwei Kulissen (65) der ersten Stütze (54,63) angeordnet sind.

10. Gerät nach Anspruch 8 oder 9, dadurch gekennzeichnet, daß es erste Blockierungseinrichtungen (56) mit manueller Betätigung aufweist, um die Drehung der ersten Stütze (54,63) auf dem zweiten Aufhängungsorgan (26) zu blockieren, und zweite Blockierungseinrichtungen (72) mit manueller Betätigung aufweist, um die horizontale Bewegung der zweiten Stütze (70) bezüglich der ersten (54,63) zu blockieren.

11. Gerät nach Anspruch 10, dadurch gekennzeichnet, daß es darüber hinaus dritte Blockierungseinrichtungen (83) mit manueller Handhabung und Steuerung aufweist, um die Drehung des Blocks (81) auf der zweiten Stütze (70) um die zweite vertikale Achse (ϑz) zu blockieren.

12. Gerät nach einem der vorhergehenden Ansprüche, bei dem der Prüfkopf durch einen radialen Arm (12) verlängert ist, dadurch gekennzeichnet, daß die Ausrichteinrichtung (16) einen Rahmen (90) aufweist, der drehbeweglich an dem Block (81) um eine Achse (ϑx) angebracht ist, und Einrichtungen zur drehbaren Lagerung des radialen Armes (12) des Prüfkopfes (11) an dem Rahmen (90) um eine zusätzliche Achse (ϑy), senkrecht zur horizontalen Achse (ϑx), aufweist.

13. Gerät nach Anspruch 12, dadurch gekennzeichnet, daß die Einrichtungen zum drehbaren Anbringen des radialen Armes (12) Zentrierungsorgane (97) aufweist, die an dem Rahmen (90) in gleichen Abständen von der zusätzlichen Achse (ϑy) angeordnet sind und eine Scheibe (100) aufweisen, die in Anlage auf die Zentrierungsorgane (97) angebracht ist, um um die zusätzliche Achse (ϑy) drehen zu können wobei der radiale Arm (12) des Prüfkopfes (11) an der Scheibe (100) befestigt ist.

14. Gerät nach Anspruch 13, dadurch gekennzeichnet, daß der Rahmen (90) einen ersten Bereich (90a), der drehbeweglich auf dem Block (81) um die horizontale Achse (ϑx) angeordnet ist und geeignet ist, partiell die Scheibe (100) zu umgeben, und einen zweiten Bereich (90b) aufweist, der schwenkbeweglich bezüglich des ersten Bereichs (90a) zwischen einer geschlossenen Stellung, bei der die Scheibe (100) zwischen den beiden Bereichen den Rahmens (90) und einer offenen Position gehaltan ist, bei der die Scheibe (100) von dem Rahmen (90) mit dem an der Scheibe befestigten Prüfkopf (11) losgelöst ist.

15. Gerät nach Anspruch 13 oder 14, dadurch gekennzeichnet, daß es ein Blockierungsorgan (110) mit manueller Bedienung aufweist, das an dem Rahmen (90) angebracht ist, um die Drehung der Scheibe um die zusätzliche Achse (ϑy) zu verhindern.

16. Gerät nach einem der Ansprüche 12 bis 15, dadurch gekennzeichnet, daß es darüber hinaus Einstelleinrichtungen (94) aufweist, um bezüglich des Blocks (81) den Rahmen (90) in einer winkelmäßig einstellbaren stabilen Position um die horizontale Achse (ϑx) zu halten, um zu verhindern, daß der Prüfkopf sich um diese horizontale Achse (ϑx) unter der Einwirkung seines Gewichts neigt.

17. Gerät nach Anspruch 16, dadurch gekennzeichnet, daß die Einstelleinrichtungen (94) manuell einstellbare Verbindungseinrichtungen aufweisen, die zwischen dem Block (81) und dem Rahmen (90) angeordnet sind, um den Rahmen (90) bezüglich des Blocks (81) über einen begrenzten Bereich der Winkelstellungen um die horizontale Achse (ϑx) zu bewegen.

18. Gerät nach Anspruch 17, dadurch gekennzeichnet, daß die Einstelleinrichtungen (94) eine Einstellschraube (124) aufweisen, die den Block (81) mit dem Rahmen (90) derart verbindet, daß eine manuelle Drehung der Schraube (124) die Drehung des Rahmens (90) bezüglich des Blocks (81) um die horizontale Achse (ϑx) erzeugt.

19. Gerät nach Anspruch 17, dadurch gekennzeichnet, daß die Einstelleinrichtungen (94) einen Nocken (119) aufweisen, der drehbar an dem Block (81) um eine Achse (118) parallel zur horizontalen Achse (ϑx) angeordnet ist, und in Anlage an den Rahmen (90) derart kommt, daµ eine manuelle Drehbewegung des Nockens (119) die Drehung des Rahmens (90) bezüglich des Blocks (81) um die horizontale Achse (ϑx) erzeugt.
